# EUROPÄISCHE PATENTANMELDUNG

(11) **EP 2 508 844 A1**
(43) Veröffentlichungstag der Anmeldung: **10.10.2012**
(21) Anmeldenummer: 11161600.9
(22) Anmeldetag: 08.04.2011
(51) Int. Cl.: G01B 11/06, B05B 12/08, F01D 5/18, C23C 14/54, G01B 5/06

(54) **Verfahren zum Bestimmen einer Beschichtungsdicke**

(71) Anmelder: SIEMENS AKTIENGESELLSCHAFT, 80333 München (DE)
(72) Erfinder: Melzer-Jokisch, Torsten, 15366 Neuenhagen bei Berlin (DE); Oppert, Andreas, 14612 Falkensee (DE); Thomaidis, Dimitrios, 14197 Berlin (DE)

(57) **Zusammenfassung**

Die vorliegende Erfindung betrifft ein Verfahren zum Bestimmen der Dicke der während eines Bauteilbeschichtungsprozesses auf ein Bauteil aufgetragenen Beschichtung, wobei das Verfahren die Schritte aufweist: Definieren eines Koordinatenursprungs, insbesondere an einer Position des zu beschichtenden Bauteils, die während des Beschichtungsprozesses keinem Verzug unterworfen ist; Befestigen von wenigstens zwei jeweils eine Referenzebene definierenden Referenzelementen an Bauteilpositionen, die während des Beschichtungsprozesses einem Verzug unterworfen sind; Durchführen einer ersten geometrischen Vermessung des Bauteils und der an diesem gehaltenen Referenzelemente vor der Durchführung des Bauteilbeschichtungsprozesses; Beschichten des Bauteils; Durchführen einer zweiten geometrischen Vermessung des beschichteten Bauteils und der an diesem gehaltenen Referenzelemente; Berechnen des Bauteilverzugs basierend auf verzugsbedingten Lageänderungen der durch die Referenzelemente definierten Referenzebenen; Berechnen der Dicke der auf das Bauteil aufgetragenen Beschichtung basierend auf einem Vergleich von im Rahmen der geometrischen Vermessungen erfassten Geometriedaten und unter Berücksichtigung des ermittelten Bauteilverzugs und Entfernen der Referenzelemente.

## Beschreibung

Die vorliegende Erfindung betrifft ein Verfahren zum Bestimmen der Dicke der während eines Bauteilbeschichtungsprozesses auf ein Bauteil aufgetragenen Beschichtung.

Bei der Beschichtung von Bauteilen ist es im Rahmen der Qualitätskontrolle erforderlich, die Beschichtungsdicke nach Durchführung eines Bauteilbeschichtungsprozesses punktuell oder großflächig zu überprüfen, um das Arbeitsergebnis beurteilen und eine ordnungsgemäße Funktionsweise des Bauteils im späteren Betrieb gewährleisten zu können.

Eine Möglichkeit zur Beschichtungsdickenüberprüfung besteht beispielsweise darin, die Beschichtung zu zerstören und die Beschichtungsdicke im Anschluss unter dem Mikroskop oder mit anderen Hilfsmitteln zu erfassen. Eine solche zerstörende Prüfung schließt jedoch den späteren Einsatz des Bauteils aus, weshalb sie nach Möglichkeit nur zur Parameteroptimierung eines Bauteilbeschichtungsprozesses eingesetzt wird.

Alternativ kann die Dicke einer Bauteilbeschichtung, wie es beispielsweise in der US-A-2005/0137829 beschrieben ist, auch im Rahmen eines Laser-Triangulations-Messverfahrens erfasst werden. Hierbei wird das Bauteil an vorab definierten Punkten oder Flächen vor und nach dem Bauteilbeschichtungsprozess vermessen, so dass sich auf Basis eines Vergleichs der im Rahmen der Vermessungen erzielten Geometriedaten die Beschichtungsdicke bestimmen lässt. Dabei ist es empfehlenswert, das Bauteil vor der Durchführung der geometrischen Vermessung des beschichteten Bauteils zunächst abkühlen zu lassen, so dass die Messergebnisse durch die thermische Ausdehnung des Bauteils aufgrund der während des Bauteilbeschichtungsprozesses vorherrschenden hohen Temperaturen nicht zu sehr verfälscht wird. Der Bauteilverzug selbst, der während des Bauteilbeschichtungsprozesses stattfindet, wird allerdings nicht berücksichtigt. Entsprechend sind Fehler bei der Bestimmung der Beschichtungsdicke im Falle eines durch den Beschichtungsprozess verursachten Bauteilverzugs nicht zu vermeiden.

Ausgehend von diesem Stand der Technik ist es somit eine Aufgabe der vorliegenden Erfindung, ein Verfahren der eingangs genannten Art zu schaffen, bei dem ein während des Bauteilbeschichtungsprozesses auftretender Verzug bei der Bestimmung der Beschichtungsdicke eines Bauteils berücksichtigt wird.

Zur Lösung dieser Aufgabe schafft die vorliegende Erfindung ein Verfahren der eingangs genannten Art, das die Schritte aufweist: Definieren eines Koordinatenursprungs, insbesondere an einer Position des zu beschichtenden Bauteils, die während des Beschichtungsprozesses keinem Verzug unterworfen ist; Befestigen von wenigstens zwei jeweils eine Referenzebene definierenden Referenzelementen an Bauteilpositionen, die während des Beschichtungsprozesses einem Verzug unterworfen sind;
Durchführen einer ersten geometrischen Vermessung des Bauteils und der an diesem gehaltenen Referenzelemente vor der Durchführung des Bauteilbeschichtungsprozesses; Beschichten des Bauteils; Durchführen einer zweiten geometrischen Vermessung des beschichteten Bauteils und der an diesem gehaltenen Referenzelemente; Berechnen des Bauteilverzugs basierend auf verzugsbedingten Lageänderungen der durch die Referenzelemente definierten Referenzebenen; Berechnen der Dicke der auf das Bauteil aufgetragenen Beschichtung basierend auf einem Vergleich von im Rahmen der geometrischen Vermessungen erfassten Geometriedaten und unter Berücksichtigung des ermittelten Bauteilverzugs und Entfernen der Referenzelemente.

Dank der an dem zu beschichteten Bauteil befestigten Referenzelemente werden bei dem erfindungsgemäßen Verfahren eindeutige Referenzebenen erzeugt. Die Referenzebenen werden jeweils durch zumindest drei Punkte aufgespannt und können sowohl gegenständlich bzw. körperlich an den Referenzebenen angeordnet sein als auch imaginär durch diese definiert werden. Die Referenzelemente werden an Bauteilpositionen angeordnet, die während des Bauteilbeschichtungsprozesses einem Verzug unterworfen sind. Die Anzahl und die Anordnung der Referenzelemente werden dabei in Abhängigkeit von der Geometrie und der Größe des zu beschichtenden Bauteils gewählt. Verzieht sich das Bauteil während des Beschichtungsprozesses, so geht dieser Verzug mit Lage- bzw. Ausrichtungsänderungen der Referenzelemente und entsprechend mit Lageänderungen der durch diese definierten Referenzebenen einher. Basierend auf diesen verzugsbedingten Lageänderungen der Referenzebenen lässt sich der Bauteilverzug in Bezug auf den Koordinatenursprung rechnerisch bestimmen. Der berechnete Verzug wird dann bei der sich anschließenden Berechnung der Beschichtungsdicke, die auf einem Vergleich von im Rahmen der geometrischen Vermessungen erfassten Geometriedaten vor und nach dem Beschichtungsprozess beruht, berücksichtigt, wodurch sich die auf das Bauteil aufgetragene Beschichtungsdicke sehr genau bestimmen lässt. Mit anderen Worten können Fehler bei der Bestimmung der Beschichtungsdicke weitestgehend eliminiert werden.

Das erfindungsgemäße Verfahren, das einen hohen Automatisierungsgrad aufweist, kann während der Prozessqualifizierung, als prozessbegleitende Messung oder als zerstörungsfreie Qualitätskontrolle zum Bestimmen der Dicke einer während eines Bauteilbeschichtungsprozesses auf ein Bauteil aufgetragenen Beschichtung eingesetzt werden. Bei dem Bauteil kann es sich sowohl um ein neu gefertigtes Bauteil als auch um ein entschichtetes Bauteil handeln, das bereits im Einsatz war und wiederaufbereitet werden soll. Der Begriff "Beschichten" ist vorliegend allgemein als Materialauftrag zu verstehen und schließt somit die vollständige oder lokale Beschichtung eines Bauteils ein, insbesondere die Herstellung von metallischen und keramischen Schichten. Als Beschichtungsverfahren können beispielsweise das atmosphärische Plasmaspritzen
(APS), das Vakuumplasmaspritzen (VPS), das PVD-Beschichtungsverfahren (Physical Vapor Deposition), das CVD-Beschichtungsverfahren (Chemical Vapor Deposition) oder dergleichen eingesetzt werden, aber auch Schweißauftragsverfahren oder ähnliches.

Bevorzugt sind die Abmessungen und das Material der Referenzelemente derart gewählt, dass die Geometrie der Referenzelemente während des Bauteilbeschichtungsprozesses konstant bleibt. Entsprechend sind die Referenzelemente während des Bauteilbeschichtungsprozesses keinem Verzug unterworfen, so dass die durch diese definierten Referenzebenen nicht verfälscht werden können.

Gemäß einer Ausgestaltung der vorliegenden Erfindung sind die Referenzelemente im Wesentlichen stiftförmig ausgebildet, wobei sich die zugehörigen Referenzebenen bevorzugt senkrecht zur Längsachse der stiftförmigen Referenzelemente erstrecken.

Vorteilhaft werden die Referenzelemente in an dem Bauteil vorhandenen Öffnungen befestigt, wodurch die Montage der Referenzelemente vereinfacht wird. Die Festlegung der Referenzelemente an dem Bauteil kann mechanisch, beispielsweise mit einer Schraubverbindung, und/oder stoffschlüssig mittels Löten, Schweißen oder dergleichen erfolgen.

Gemäß einer Ausgestaltung der vorliegenden Erfindung ist das zu beschichtende Bauteil eine Turbinenschaufel, wobei der Koordinatenursprung bevorzugt an einer Position im Bereich des Schaufelfußes befestigt wird und/oder die Referenzelemente bevorzugt beabstandet voneinander an einer Anströmkante befestigt werden. Der Schaufelfuß einer Turbinenschaufel wird während eines Beschichtungsprozesses, bei dem die Schaufelblattoberfläche der Turbinenschaufel beispielsweise mit einer Wärmebarrierebeschichtung oder dergleichen versehen wird, nicht beschichtet, weshalb er verhältnismäßig geringen Temperaturen ausgesetzt wird. Auch weist der Schaufelfuß meist einen im Vergleich zum Schaufelblatt massiven Aufbau auf, so dass ein Verzug des Schaufelfußes während des Beschichtungsprozesses nicht zu befürchten ist. Entsprechend ist eine Position am Schaufelfuß für den Koordinatenursprung eine besonders günstige Wahl. Die Anströmkante eignet sich dahingehend besonders für die Anordnung der Referenzelemente, dass diese normalerweise mit Öffnungen versehen ist, in denen die Referenzelemente positioniert werden können.

Die geometrischen Vermessungen werden bevorzugt mittels Laser-Triangulation durchgeführt. Mithilfe der Laser-Triangulation lassen sich geometrische Daten eines Bauteils einfach und schnell erfassen.

Vorteilhaft wird die Beschichtungsdicke an vorbestimmten Bauteilpositionen berechnet, insbesondere an Bauteilpositionen, an denen besonders häufig ungewollte Variationen der Beschichtungsdicke auftreten. Durch die Wahl einzelner vorbestimmter Bauteilpositionen lässt sich der für die Durchführung des Verfahrens erforderliche Rechenaufwand und somit auch der zeitliche Aufwand stark reduzieren.

Gemäß einer Ausgestaltung des erfindungsgemäßen Verfahrens weist dieses die weiteren Schritte auf: Durchführen einer geometrischen Vermessung eines neuen, bereits beschichteten Bauteils und Berechnen des Bauteilverzugs, der auf die während des Einsatzes des Bauteils auf das Bauteil einwirkenden Belastungen zurückzuführen ist, basierend auf einem Vergleich der im Rahmen der geometrischen Vermessung des neuen Bauteils erfassten Geometriedaten und der im Rahmen der nach dem Beschichtungsprozess durchgeführten geometrischen Vermessung erfassten Geometriedaten des wiederaufbereiteten Bauteils. Mit anderen Worten werden bei dieser Variante die Geometriedaten eines beschichteten Bauteils im Neuzustand und im wieder aufbereiteten Zustand, die bezogen auf denselben Koordinatenursprung erfasst wurden, miteinander verglichen, womit sich der betriebsbedingte Verzug eines Bauteils berechnen lässt.

Weitere Vorteile und Merkmale der vorliegenden Erfindung werden anhand der nachfolgenden Beschreibung eines Verfahrens gemäß einer Ausführungsform der vorliegenden Erfindung unter Bezugnahme auf die beiliegende Zeichnung deutlich. Darin ist
- Figur 1: eine perspektivische Ansicht eines beschichteten und einsatzbereiten Bauteils;
- Figur 2: eine perspektivische Ansicht des in Figur 1 dargestellten Bauteils vor der Herstellung der Beschichtung, wobei das Bauteil zur Durchführung des erfindungsgemäßen Verfahrens mit Referenzelementen versehen wird; und
- Figur 3: eine perspektivische Ansicht des in Figur 2 dargestellten Bauteils unmittelbar nach der Durchführung des Bauteilbeschichtungsprozesses.

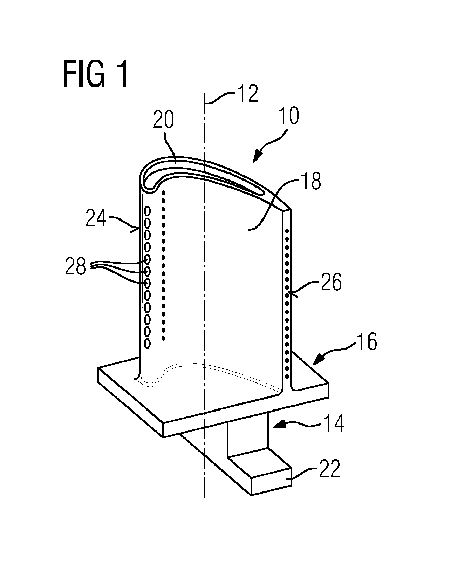

Figur 1 zeigt eine mit einer Beschichtung versehene Turbinenschaufel 10 als Beispiel eines Bauteils, das unter Einsatz des nachfolgend im Einzelnen beschriebenen Verfahrens gemäß einer Ausführungsform der vorliegenden Erfindung hergestellt wurde. Bei der Turbinenschaufel 10 kann es sich um eine Laufschaufel oder eine Leitschaufel einer Strömungsmaschine handeln.

Die Turbinenschaufel 10 weist entlang ihrer Längsachse 12 von unten nach oben betrachtet aufeinander folgend einen Befestigungsbereich 14, eine daran angrenzende Schaufelplattform 16 und ein Schaufelblatt 18 mit einer Schaufelspitze 20 auf. Im Befestigungsbereich 14 ist ein Schaufelfuß 22 ausgebildet, der zur Befestigung der Turbinenschaufel 10 an einer Welle oder an einer Nabe dient. Der Schaufelfuß 22 ist vorliegend als Hammerkopf ausgestaltet, wobei auch andere Ausgestaltungen möglich sind. Das Schaufelblatt 18 definiert eine Anströmkante 24 und eine Abströmkante 26 für ein an diesem vorbeiströmendes Medium. Als Leitschaufel kann die Schaufelspitze 20 mit einer weiteren Plattform versehen sein, was vorliegend jedoch nicht dargestellt ist.

Der Grundkörper der Turbinenschaufel 10, der beispielsweise einteilig aus einem metallischen Werkstoff hergestellt sein kann, wie beispielsweise aus einer Superlegierung oder dergleichen, ist im Bereich des Schaufelblattes 18 mit zumindest einer Beschichtung versehen. Bei dieser Beschichtung kann es sich beispielsweise um eine solche gegen Korrosion oder Oxidation handeln, z. B. eine MCrAlX-Beschichtung, wobei M zumindest ein Element der Gruppe Eisen, Kobalt und Nickel ist und X ein Aktivelement ist und für Yttrium und/oder Silizium und/oder zumindest ein Element der seltenen Erden bzw. Hafnium steht.

Alternativ oder zusätzlich kann auf das Schaufelblatt 18 eine Wärmedämmschicht als Beschichtung aufgetragen sein, die vorzugsweise die äußerste Schicht darstellt und beispielsweise aus ZrO₂, Y_{y}O₃ZrO₂ oder dergleichen besteht.

Die Turbinenschaufel 10 ist vorliegend hohl ausgebildet, so dass sie mit einem entsprechenden Kühlmittel während ihres Betriebs gekühlt werden kann. Darüber hinaus ist sie mit Kühllöchern 28 versehen.

Während des Betriebs muss die Turbinenschaufel 10 hohen äußeren Belastungen standhalten, insbesondere hohen thermischen Belastungen aufgrund des heißen Arbeitsmediums. Dabei wird die Turbinenschaufel 10 von außen regelmäßig beschädigt, so dass sie in entsprechenden Zyklen wieder aufgearbeitet werden muss. Im Rahmen dieser Wiederaufbereitung wird die Turbinenschaufel 10 zunächst von den äußeren Schutzschichten befreit, was beispielsweise mittels Sandstrahlen erfolgen kann. Danach werden die Korrosions- und/oder Oxidationsschichten entfernt. Ggf. werden auch noch Risse in der Turbinenschaufel 10 repariert. Anschließend erfolgt eine Wiederbeschichtung der Turbinenschaufel 10, so dass diese wieder in Betrieb genommen werden kann.

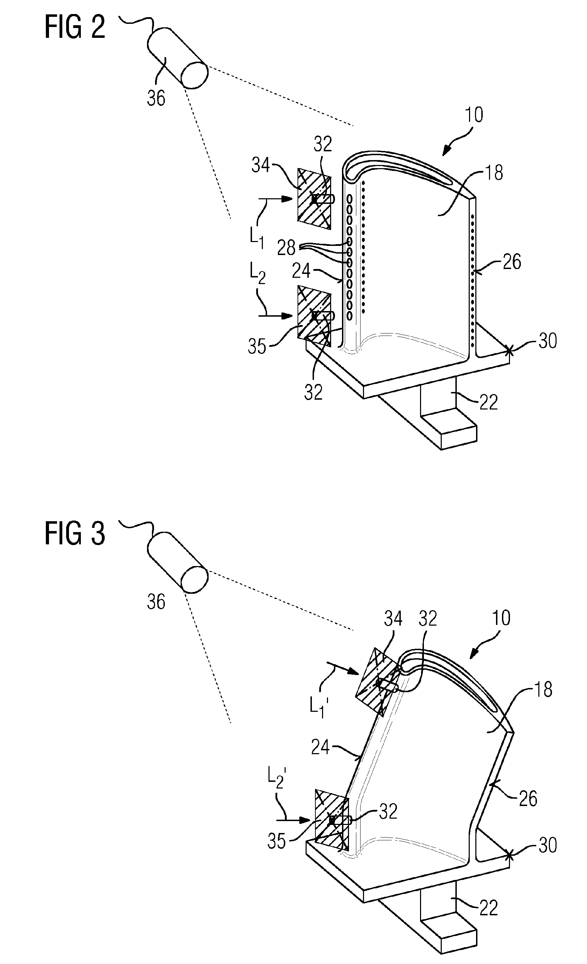

Um sicherzustellen, dass die Turbinenschaufel 10 während eines Bauteilbeschichtungsprozesses zur Herstellung der zuvor genannten Korrosions- oder Oxidationsschicht und/oder der Wärmedämmschicht mit einer entsprechenden Beschichtung der gewünschten Soll-Dicke versehen wurde, werden gemäß einer Ausführungsform eines erfindungsgemäßen Verfahrens folgende Schritte durchgeführt:
Ausgangspunkt ist eine in Figur 2 dargestellte, mit einer Beschichtung zu versehene Turbinenschaufel 10, bei der es sich um ein neues Bauteil oder um ein bereits gebrauchtes Bauteil handelt, dessen äußere Beschichtung bereits entfernt wurde.
In einem ersten Schritt wird ein Koordinatenursprung 30 an einer Position des Schaufelfußes 22 definiert. Die Wahl einer Koordinatenursprungsposition im Bereich des Schaufelfußes 22 ist dahingehend von Vorteil, dass die Abmessungen des Schaufelfuß 22 aus den eingangs bereits genannten Gründen während eines Beschichtungsprozesses zum Beschichten des Schaufelblattes 18 keinem Verzug unterworfen und somit konstant sind.
In einem weiteren Schritt werden zwei stiftartig ausgebildete Referenzelemente 32 übereinander und beabstandet voneinander in an der Anströmkante 24 des Schaufelblattes 18 vorhandenen Kühllöchern 28 befestigt. Die Abmessungen und Materialien der Referenzelemente 32 sind derart gewählt, dass die Geometrie der Referenzelemente 32 während des durchzuführenden Beschichtungsprozesses keinem Verzug unterworfen ist. Die Befestigung der Referenzelemente 32 kann beispielsweise mittels Hartlöten oder dergleichen erfolgen. Die Referenzelemente 32 definieren jeweils eine imaginäre Referenzebene 34, 35, die sich vorliegend senkrecht zur Haupterstreckungsrichtung L₁, L₂ des entsprechenden Referenzelementes 32 erstreckt. An dieser Stelle sei darauf hingewiesen, dass auch mehr als zwei Referenzelemente 32 an dem Schaufelblatt 18 befestigt werden können. Je höher die Anzahl der Referenzelemente 32 ist, desto genauer kann der während des Beschichtungsprozesses stattfindende Bauteilverzug berechnet werden, worauf nachfolgend noch näher eingegangen wird.

Nach Anordnung der Referenzelemente 32 wird unter Verwendung einer Vermessungseinrichtung 36 eine erste geometrische Vermessung der Turbinenschaufel 10 und der an dieser gehaltenen Referenzelemente 32 im noch nicht beschichteten Zustand der Turbinenschaufel 10 durchgeführt. Auf diese Weise werden auch die Positionen und Ausrichtungen der zugehörigen Referenzebenen 34, 35 ermittelt. Die Vermessung erfolgt vorliegend mittels Laser-Triangulation, wie es in Figur 1 schematisch dargestellt ist. Das Laser-Triangulations-Vermessungsverfahren ist hinlänglich bekannt, weshalb dieses und die eingesetzte Vermessungseinrichtung 36 nachfolgend nicht näher erläutert werden. Die während der Bauteilvermessung gewonnenen Geometriedaten, die in Bezug auf den Koordinatenursprung 30 erfasst wurden, werden in einer nicht näher dargestellten Recheneinheit gespeichert.

Nach der Durchführung der zuvor beschriebenen geometrischen Vermessung wird das Schaufelblatt 18 der Turbinenschaufel 10 in einem entsprechenden Bauteilbeschichtungsprozess beschichtet. Als Beschichtungsverfahren können beispielsweise das atmosphärische Plasmaspritzen (APS), das Vakuumplasmaspritzen (VPS), das PVD-Beschichtungsverfahren (Physical Vapor Deposition), das CVD-Beschichtungsverfahren (Chemical Vapor Deposition) oder dergleichen eingesetzt werden, aber auch Schweißauftragsverfahren oder ähnliches. Während des Bauteilbeschichtungsprozesses soll eine vorbestimmte Soll-Schichtdicke erzielt werden, die über das Schaufelblatt 18 konstant sein oder lokal variieren kann.

Während des Beschichtungsprozesses erfährt das Schaufelblatt 18 der Turbinenschaufel 10 aufgrund der vorherrschenden hohen Temperaturen einen Verzug, wie es in Figur 3 übertrieben dargestellt ist. Dieser Verzug führt dazu, dass sich die Position und die Ausrichtung der Haupterstreckungsrichtungen L₁, L₂ der Referenzelemente 32 und somit auch die Lage der durch diese definierten Referenzebenen 34, 35 bezogen auf den Koordinatenursprung 30 verändern, was in Figur 3 jeweils durch ein Apostroph "'" gekennzeichnet ist.

In einem weiteren Schritt wird unter Verwendung der Vermessungseinrichtung 36 eine zweite geometrische Vermessung der nunmehr beschichteten Turbinenschaufel 10 und der an dieser gehaltenen Referenzelemente 32 durchgeführt. Hierbei wird ein zweiter Satz von auf dem Koordinatenursprung 30 basierenden Geometriedaten erzeugt. Im Anschluss wird der Verzug des Schaufelblattes 18 basierend auf den verzugsbedingten Lageänderungen der durch die Referenzelemente 32 definierten Referenzebenen 34, 35 berechnet. Daraufhin wird die Ist-Dicke der auf das Schaufelblatt 18 der Turbinenschaufel 10 aufgetragene Beschichtung basierend auf einem Vergleich der im Rahmen der beiden geometrischen Vermessungen erfassten ersten und zweiten Geometriedatensätze und unter Berücksichtigung des ermittelten Bauteilverzugs berechnet. Entsprechend können nunmehr für entsprechende Schaufelblattpositionen berechnete Ist-Beschichtungsdicken mit den zugeordneten Soll-Beschichtungsdicken verglichen werden, so dass eine Beurteilung des Beschichtungsergebnisses möglich ist.

Dank der Tatsache, dass bei der Bestimmung der Ist-Beschichtungsdicke der Bauteilverzug berücksichtigt wird, werden die erzielten Messergebnisse nicht durch den Bauteilverzug verfälscht.

In einem letzten Schritt werden die Referenzelemente 32 wieder von der Turbinenschaufel 10 entfernt.

Zur Berechnung eines Verzugs der Turbinenschaufel 10, der auf während des Betriebs der Turbinenschaufel 10 auftretende Belastungen zurückzuführen ist, wird in einem ersten Schritt die Geometrie einer neuen, mit einer Beschichtung versehene Turbinenschaufel 10, wie sie in Figur 1 dargestellt ist, unter Verwendung der Vermessungseinrichtung 36 bezogen auf den oben genannten Koordinatenursprung vermessen. Die bei dieser Vermessung ermittelten Geometriedaten werden wiederum in einem nicht näher dargestellten Speicher einer Rechenanlage hinterlegt.

Die Wiederaufbereitung der Turbinenschaufel 10 nach ihrem Einsatz erfolgt dann unter Verwendung des zuvor unter Bezugnahme auf die Figuren 1 bis 3 beschriebenen Verfahrens.

Anhand eines Vergleiches der Geometriedaten der neuen Turbinenschaufel 10 mit den Ist-Geometriedaten der Turbinenschaufel 10 nach ihrer Wiederaufbereitung lässt sich nunmehr der Verzug der Turbinenschaufel 10 berechnen, der auf während des Betriebs der Turbinenschaufel 10 auftretende Belastungen zurückzuführen ist.

## Patentansprüche

1. Verfahren zum Bestimmen der Dicke der während eines Bauteilbeschichtungsprozesses auf ein Bauteil (10) aufgetragenen Beschichtung, wobei das Verfahren die Schritte aufweist:
- Definieren eines Koordinatenursprungs (30), insbesondere an einer Position des zu beschichtenden Bauteils (10), die während des Beschichtungsprozesses keinem Verzug unterworfen ist;
- Befestigen von wenigstens zwei jeweils eine Referenzebene (34, 35) definierenden Referenzelementen (32) an Bauteilpositionen, die während des Beschichtungsprozesses einem Verzug unterworfen sind;
- Durchführen einer ersten geometrischen Vermessung des Bauteils und der an diesem gehaltenen Referenzelemente (32) vor der Durchführung des Bauteilbeschichtungsprozesses;
- Beschichten des Bauteils (10);
- Durchführen einer zweiten geometrischen Vermessung des beschichteten Bauteils (10) und der an diesem gehaltenen Referenzelemente (32);
- Berechnen des Bauteilverzugs basierend auf verzugsbedingten Lageänderungen der durch die Referenzelemente (32) definierten Referenzebenen (34, 35);
- Berechnen der Dicke der auf das Bauteil (10) aufgetragenen Beschichtung basierend auf einem Vergleich von im Rahmen der geometrischen Vermessungen erfassten Geometriedaten und unter Berücksichtigung des ermittelten Bauteilverzugs und
- Entfernen der Referenzelemente (32).

2. Verfahren nach Anspruch 1,
**dadurch gekennzeichnet, dass**
die Abmessungen und das Material der Referenzelemente (32) derart gewählt sind, dass die Geometrie der Referenzelemente (32) während des Bauteilbeschichtungsprozesses konstant bleibt.

3. Verfahren nach einem der vorhergehenden Ansprüche, **dadurch gekennzeichnet, dass**
die Referenzelemente (32) im Wesentlichen stiftförmig ausgebildet sind.

4. Verfahren nach einem der vorhergehenden Ansprüche, **dadurch gekennzeichnet, dass**
die Referenzelemente (32) in an dem Bauteil (10) vorhandenen Öffnungen (28) befestigt werden.

5. Verfahren nach einem der vorhergehenden Ansprüche, **dadurch gekennzeichnet, dass**
das Bauteil (10) eine Turbinenschaufel ist, wobei der Koordinatenursprung (30) bevorzugt an einer Position im Bereich des Schaufelfußes (22) und/oder die Referenzelemente (32) bevorzugt beabstandet voneinander an einer Anströmkante (24) befestigt werden.

6. Verfahren nach einem der vorhergehenden Ansprüche, **dadurch gekennzeichnet, dass**
die geometrischen Vermessungen mittels Laser-Triangulation durchgeführt werden.

7. Verfahren nach einem der vorhergehenden Ansprüche, **dadurch gekennzeichnet, dass**
die Beschichtungsdicke an vorbestimmten Bauteilpositionen berechnet wird.

8. Verfahren nach einem der vorhergehenden Ansprüche, **dadurch gekennzeichnet, dass**
das Verfahren die weiteren Schritte aufweist:
- Durchführen einer geometrischen Vermessung eines neuen, bereits beschichteten Bauteils (10) und
- Berechnen des Bauteilverzugs, der auf die während des Einsatzes des Bauteils (10) auf das Bauteil (10) einwirkenden Belastungen zurückzuführen ist, basierend auf einem Vergleich der im Rahmen der geometrischen Vermessung des neuen Bauteils (10) erfassten Geometriedaten und der im Rahmen der nach dem Beschichtungsprozess durchgeführten geometrischen Vermessung erfassten Geometriedaten des wiederaufbereiteten Bauteils (10).
